# EUROPEAN PATENT SPECIFICATION

(11) **EP 3 547 350 B1**
(45) Date of publication and mention of the grant of the patent: **21.10.2020**
(21) Application number: 17881400.0
(22) Date of filing: 06.12.2017
(51) Int. Cl.: H01L 21/20, H01L 21/205

(54) **METHOD FOR REDUCING IMPACT OF BASAL PLANE DISLOCATION ON SILICON CARBIDE EPITAXIAL LAYER**
VERFAHREN ZUR VERRINGERUNG DES EINFLUSSES EINER BASALEN EBENENVERSCHIEBUNG AUF EINE SILICIUMCARBID-EPITAXIALSCHICHT
PROCÉDÉ DE RÉDUCTION DE L'IMPACT D'UNE DISLOCATION DE PLAN BASAL SUR UNE COUCHE ÉPITAXIALE DE CARBURE DE SILICIUM

(30) Priority: 15.12.2016 CN 201611159148
(43) Date of publication of application: 02.10.2019
(73) Proprietor: China Electronics Technology Group Corporation No.55 Research Institute, Nanjing, Jiangsu 210016 (CN)
(72) Inventor: LI, Yun, Nanjing Jiangsu 210016 (CN)
(74) Representative: Hanna Moore + Curley
(86) International application number: PCT/CN2017/114685
(87) International publication number: WO 2018/108005

(56) References cited:
- CN-A- 101 599 428
- CN-A- 105 369 217
- CN-A- 105 826 186
- CN-A- 105 826 186
- CN-A- 106 711 031
- JP-A- 2013 018 659
- US-A1- 2009 302 328
- US-A1- 2012 241 766

## Description

### Technical Field

The present invention relates to a growth method of a silicon carbide epitaxial layer with high surface quality, and more particularly relates to a method for reducing the extension of a basal plane dislocation on a silicon carbide epitaxial layer.

### Background Art

The perfection of existing commercial silicon carbide substrate crystals is greatly improved, but there is still a large number of Basal Plane Dislocations (BPD) in a silicon carbide substrate. The BPD may possibly extend to an epitaxial layer and will be evolved into a Stacking Fault (SF) under the action of a forward conduction current, causing a drift of a forward conduction voltage of a bipolar device. Since a Threading Edge Dislocation (TED) has much smaller influence on the device performance, increase of the conversion ratio of the BPD to the TED during silicon carbide epitaxial layer growth and prevention of the BPD in the substrate from extending into the epitaxial layer are very important to improve the device performance. At present, the conversion efficiency of the BPD to the TED can be greatly improved by adopting a method of replacing an 8-degree off-axis substrate by a 4-degree off-axis substrate and a method of pretreating a substrate by KOH melting corrosion.

However, a new SF will be still derived from even the converted TED defect in case of high current injection, enter the epitaxial layer and affect the device performance. Under the action of the forward conduction current, the SF is mainly formed by an incomplete dislocation movement of the BPD defect, and energy for activating the dislocation movement is from electron-hole recombination. The electron-hole recombination rate is in inverse proportion to a doping concentration. Therefore, it is very hard to form the SF by the BPD defect in a buffer layer with a high doping concentration. The deeper the conversion position, the greater the injection current required by derivation of the SF from the BPD. Therefore, in order to reduce the extension of the BPD defect on the device performance, a very thick highly doped buffer layer (10 µm or more) is grown to make a BPD conversion position deeper to get away from the interfaces of the buffer layer and epitaxial layer. However, this method is not desirable and will greatly prolong the epitaxial process time, resulting in an increase in expenses. Furthermore, if a concentration difference between the buffer layer and the epitaxial layer is large, stress is also introduced into the epitaxial layer to cause reduction of the quality of crystals.

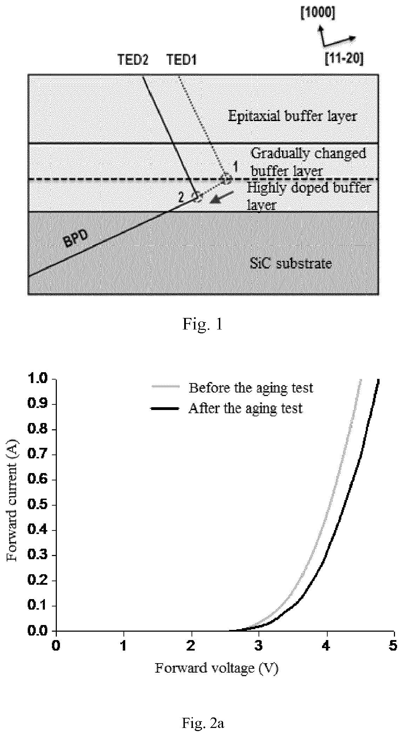

The converted TED may slide at a high temperature (1,700°C or above) under the action of a dislocation linear tension and a surface image force. During the sliding, a TED feature length is reduced and the energy is reduced. This is a spontaneous process and can occur repeatedly and finally promote a BPD-TED defect conversion point to move down, as shown in Fig. 1, from TED1 to TED2. However, in a high-temperature annealing process, due to the high temperature, the etching rate of hydrogen to silicon carbide is high, and the surface of the buffer layer is easily damaged, which results in degradation of the surface of a subsequently grown epitaxial material, so this principle has not been applied to an epitaxial process.

Patent specification CN 105826186 describes a method for growing a high-surface-quality silicon carbide epitaxial layer.

Patent specification US 2012/241766 describes an epitaxial wafer made of silicon carbide and a semiconductor element formed using the epitaxial wafer.

Patent specification US 2009/302328 describes a silicon carbide semiconductor substrate and a method of manufacturing the same.

Patent specification JP 2013/018659 describes an epitaxial wafer made of silicon carbide and a semiconductor device formed using the epitaxial wafer.

### Summary of the Invention

Invention objective: for the above problems, the present invention provides a method for reducing the extension of a basal plane dislocation on a silicon carbide epitaxial layer.

Technical solution: in order to achieve the objective of the present invention, the technical solution of the present invention is that: a method for reducing the extension of a basal plane dislocation on a silicon carbide epitaxial layer, including the following steps:
(1) placing a silicon carbide substrate on a graphite susceptor in a reaction chamber of a silicon carbide epitaxial system;
(2) replacing gas in the reaction chamber by argon for multiple times, then introducing hydrogen into the reaction chamber, gradually increasing the flow rate of the hydrogen to 60 to 120 L/min, setting a pressure in the reaction chamber to be 80 to 200 mbar, gradually heating the reaction chamber to 1,550 to 1,700°C, maintaining all parameters constant after the temperature reaches a set temperature, and performing in-situ hydrogen etching treatment on the silicon carbide substrate for 5 to 15 min;
(3) after the in-situ hydrogen etching treatment is completed, introducing a silicon source and a carbon source at small flow rates into the reaction chamber, controlling the flow rate ratio of the silicon source to the hydrogen to be smaller than 0.03%, and introducing a doping source to grow a highly doped buffer layer with a thickness of 0.5 to 5 µm and a doping concentration of about 5E18 cm⁻³;
(4) turning off the silicon and carbon source, wherein the silicon and carbon source is a growth source, and the doping source, raising the growth temperature to 1,700 to 1,900°C within 10 min in a manner of linear change, increasing the pressure in the reaction chamber to 500 to 800 mbar, reducing the flow rate of the hydrogen to 30 to 60 L/min, and performing high-temperature annealing treatment on the highly doped buffer layer for 10 to 60 min;
(5) reducing the growth temperature to 1,550 to 1,700°C within 10 min in the manner of linear change, reducing the pressure in the reaction chamber to 80 to 200 mbar, and increasing the flow rate of the hydrogen to 60 to 120 L/min;
(6) introducing the silicon source and the carbon source at small flow rates into the reaction chamber, wherein the flow rates of the silicon source and the carbon source are the same as those in the step (3); introducing the doping source, the initial flow rate of which is the same as that in the step (3), and then gradually reducing the flow rate to one-fifth to grow a gradually changed buffer layer with a thickness of 0.5 to 2 µm and a doping concentration of about 1E18 cm⁻³ gradually changed from about 5E18 cm⁻³;
(7) changing the flow rates of the growth source and the doping source to set values required by growing an epitaxial structure in a gradual linear manner, and growing the epitaxial structure according to a conventional process procedure;
(8) after the growth of the epitaxial structure is completed, turning off the growth source and the doping source, reducing the temperature of the reaction chamber to room temperature in a hydrogen atmosphere, then discharging the hydrogen, introducing argon to replace the gas in the reaction chamber for multiple times, increasing the pressure in the reaction chamber to an atmospheric pressure by the argon, and opening the chamber to take out a wafer.

Beneficial effects: compared with the prior art, the present invention is that the highly doped buffer layer is subjected to the high-temperature annealing treatment to promote a BPD-TED (Basal Plane Dislocation-Thrcading Edge Dislocation) conversion point to move down and get away from an active layer, thus lowering the probability of generating stacking fault defects caused by extension of a BPD defect into the epitaxial layer; meanwhile, damage of the high-temperature hydrogen to the highly doped buffer layer is reduced by optimizing a high-temperature annealing process; and the gradually changed buffer layer is designed to further improve the surface quality of an epitaxial material. The method is compatible with a conventional epitaxial process and suitable for batch production.

### Brief Description of the Drawings

Fig. 1 is a schematic diagram of changes of a BPD-TED conversion position in an epitaxial material;
Fig. 2a shows forward characteristics of a silicon carbide PiN diode of a conventional epitaxial material; and
Fig. 2b shows forward characteristics of a silicon carbide PiN diode of an improved epitaxial material.

### Detailed Description of the Invention

The technical solution of the present invention is further described below in combination with accompanying drawings and examples.

A method for reducing the extension of a basal plane dislocation on a silicon carbide epitaxial layer of the present invention completes high-temperature annealing treatment of a highly doped buffer layer is achieved by reducing the flow rate of hydrogen in the high-temperature annealing process and enhancing the suppression of a pressure in a reaction chamber for the etching effect of the hydrogen on a substrate, and then continuously adopts a gradually changed buffer layer grown at a low epitaxial rate to reduce a doping concentration difference between the epitaxial layer and the highly doped buffer layer and improve the surface quality of a subsequent epitaxial layer. The epitaxial method may effectively lower the probability that a basal plane dislocation in the epitaxial layer derives a stacking fault defect under the action of a high current. The process is compatible with a conventional epitaxial process. The method specifically includes the following steps that:
(1) a silicon carbide substrate is placed on a graphite susccptor in a reaction chamber of an SiC epitaxial system, wherein the graphite susceptor is provided with a tantalum carbide coating layer, and the silicon carbide substrate may use a silicon-face silicon carbide substrate deflected towards a direction <11-20> at 4 degrees or 8 degrees;
(2) gas in the reaction chamber is replaced by argon for multiple times; then hydrogen is introduced into the reaction chamber; the flow rate of the hydrogen is gradually increased to 60 to 120 L/min; a pressure in the reaction chamber is set to be 80 to 200 mbar; the reaction chamber is gradually heated to 1,550 to 1,700°C; all parameters are maintained constant after the temperature reaches a set temperature, and in-situ hydrogen etching treatment is performed on the silicon carbide substrate for 5 to 15 min;
(3) a silicon source and a carbon source at small flow rates are introduced into the reaction chamber, wherein the silicon source may be silane, dichloro hydrogen silicon, trichlorosilane, tetrachloro hydrogen silicon, etc., and the carbon source may be methane, ethylene, acetylene, propane, etc.; the flow rate ratio of the silicon source to the hydrogen is controlled to be smaller than 0.03%; the flow rate of the carbon source is adjusted; the C/Si ratio at the gas inlet end is controlled to be 0.85, and an n-type doping source high-purity nitrogen (N₂) or a p-type doping source trimethylaluminum (TMA) is introduced, namely 1,000 sccm of high-purity nitrogen (N₂) may be introduced; the growth time is set to be 24 min, and a highly doped buffer layer with a thickness of 0.5 to 5 µm and a doping concentration of about 5E18 cm⁻³ is grown;
(4) the silicon and carbon source, and the doping source are turned off; the growth temperature is raised to 1,700 to 1,900°C within 10 min in a manner of linear change; the pressure in the reaction chamber is increased to 500 to 800 mbar; the flow rate of the hydrogen is reduced to 30 to 60 L/min; high-temperature annealing treatment is performed on the highly doped buffer layer for 10 to 60 min, wherein the interfacial high-temperature annealing treatment is utilized to promote a BPD-TED conversion point to move down and get away from the surface of the highly doped buffer layer;
(5) the growth temperature is reduced to 1,550 to 1,700°C within 10 min in the manner of linear change; the pressure in the reaction chamber is reduced to 80 to 200 mbar; and the flow rate of the hyddrogen is increased to 60 to 120 L/min;
(6) the silicon source and the carbon source at small flow rates are introduced into the reaction chamber, wherein the flow rates of the silicon source and the carbon source arc the same as those in the step (3); the n-type doping source high-purity nitrogen (N₂) or the p-type doping source trimethylaluminum (TMA) is introduced, wherein the initial flow of the doping source is the same as that in the step (3) and is gradually reduced to one-fifth of this value, for example, the flow rate of the high-purity nitrogen is gradually changed from 1,000 sccm to 200 sccm; the growth time is set to be 12 min, and a gradually changed buffer layer with a thickness of 0.5 to 2 µm and a doping concentration gradually changed from about 5E18 cm⁻³ to about 1E18 cm⁻³ is grown, wherein a concentration difference between the highly doped buffer layer and the epitaxial layer is reduced by adding the gradually changed buffer layer, and the interface of the highly doped buffer layer etched by high-temperature hydrogen is repaired, so that the probability that the basal plane dislocation in the epitaxial layer derives a stacking fault defect under the action of a high current may be effectively lowered on the premise of guaranteeing the quality of epitaxial crystals;
(7) the flow rates of the growth source and the doping source are changed in a gradual, linear manner; the SiH₄/H₂ flow rate ratio is controlled to be 0.2%, and the C/Si ratio at the gas inlet end is controlled to be 1.05, and hydrogen chloride is introduced; the Cl/Si ratio at the gas inlet end is set to be 2.5, and 5 sccm of nitrogen is introduced; the epitaxial time is set to be 180 min; all the values are set to be set values required by growing an epitaxial structure; the epitaxial structure is grown according to a conventional process procedure, such as a JBS (Junction Barrier Schottky) structure, a PiN structure, a JFET (Junction Field-effect Transistor) structure, an MOSFET (Metal Oxide Semiconductor Field Effect Transistor) structure and an SIT (Static Induction Transistor) structure, wherein the doping type of the epitaxial layer is the same as the doping types of the highly doped buffer layer and the gradually changed buffer layer;
(8) after the growth of the epitaxial structure is completed, the growth source and the doping source are turned off; the temperature of the reaction chamber is reduced to room temperature in a hydrogen atmosphere; the hydrogen is discharged after the temperature of the reaction chamber reaches the room temperature; argon is introduced to replace the gas in the reaction chamber for multiple times; the pressure in the reaction chamber is increased to an atmospheric pressure by the argon; and the chamber is opened to take out a wafer.

The setting of the hydrogen flow rate in the present invention is suitable for large-sized silicon carbide epitaxial equipment. For a small-sized epitaxial furnacc, the hydrogen flow rate may be set according to an actual situation.

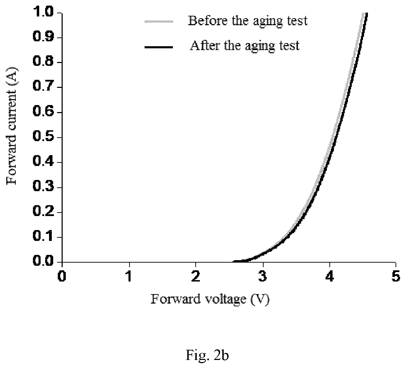

The epitaxial method may lower the basal plane dislocation conversion point to be below the interface of the highly doped buffer layer and effectively lower the probability that the basal plane dislocation in the epitaxial layer derives the stacking fault defect under the action of the high current. The process is compatible with the conventional epitaxial process. Fig. 2 shows aging test data. Fig. 2a shows forward characteristics of a silicon carbide PiN diode based on a conventional epitaxial material, and Fig. 2b shows forward characteristics of a silicon carbide PiN diode based on a process-improved epitaxial material. It can be found by comparison that before the epitaxial material is improved, a forward characteristic test of the silicon carbide PiN diode reflects a pressure drop continuous increase phenomenon; and after the epitaxial material is improved, the silicon carbide PiN diode has stable forward characteristics, which indicates that the extension of the basal plane dislocation on the silicon carbide epitaxial layer may be greatly reduced by optimizing the epitaxial process.

## Claims

1. A method for growing a silicon carbide epitaxial layer comprising reducing the extension of a basal plane dislocation on a silicon carbide epitaxial layer, comprising the following steps:
(1) placing a silicon carbide substrate deflected towards a direction <11-20> by 4 degrees or 8 degrees on a graphite susceptor in a reaction chamber of a silicon carbide epitaxial system;
(2) replacing gas in the reaction chamber by argon, then introducing hydrogen into the reaction chamber, gradually increasing the flow rate of the hydrogen to 60 to 120 L/min, setting a pressure in the reaction chamber to 80 to 200 mbar, gradually heating the reaction chamber to 1,550 to 1,700°C, maintaining all parameters constant after the temperature reaches a set temperature, and performing in-situ hydrogen etching treatment on the silicon carbide substrate for 5 to 15 min;
(3) after the in-situ hydrogen etching treatment is completed, introducing a silicon source and a carbon source into the reaction chamber, such that the flow rate ratio of the silicon source to the hydrogen is smaller than 0.03%, and the carbon source to silicon source ratio is controlled to be 0.85, and introducing a doping source to grow a highly doped buffer layer with a thickness of 0.5 to 5 µm and a doping concentration of about 5E18 cm⁻³;
(4) turning off the silicon and carbon source, wherein the silicon and carbon source is a growth source, and the doping source, raising the growth temperature to 1,700 to 1,900°C within 10 min in a manner of linear change, increasing the pressure in the reaction chamber to 500 to 800 mbar, reducing the flow rate of the hydrogen to 30 to 60 L/min, and performing high-temperature annealing treatment on the highly doped buffer layer for 10 to 60 min;
(5) reducing the growth temperature to 1,550 to 1,700°C within 10 min in the manner of linear change, reducing the pressure in the reaction chamber to 80 to 200 mbar, and increasing the flow rate of the hydrogen to 60 to 120 L/min;
(6) introducing the silicon source and the carbon source into the reaction chamber, wherein the flow rates of the silicon source and the carbon source are the same as those in the step (3); introducing the doping source, the initial flow rate of which is the same as that in the step (3), and then gradually reducing the flow rate to one-fifth to grow a gradually changed buffer layer with a thickness of 0.5 to 2 µm and a doping concentration of about 1E18 cm⁻³ gradually changed from about 5E18 cm⁻³;
(7) changing the flow rates of the growth source and the doping source to set values in a gradual, linear manner, wherein all the values are set to be set values required by growing an epitaxial structure, and growing the epitaxial structure; and
(8) after the growth of the epitaxial structure is completed, turning off the growth source and the doping source, reducing the temperature of the reaction chamber to room temperature in a hydrogen atmosphere, then discharging the hydrogen, introducing argon to replace the gas in the reaction chamber, increasing the pressure in the reaction chamber to an atmospheric pressure by the argon, and opening the chamber to take out a wafer.

2. The method for reducing the influence of the basal plane dislocation on the silicon carbide epitaxial layer according to claim 1, wherein the doping source is an n-type doping source nitrogen or a p-type doping source trimethylaluminum.

3. The method for reducing the influence of the basal plane dislocation on the silicon carbide epitaxial layer according to claim 1, wherein the silicon source is silane, dichloro hydrogen silicon, trichlorosilane or tetrachloro hydrogen silicon, and the carbon source is methane, ethylene, acetylene or propane.

4. The method for reducing the influence of the basal plane dislocation on the silicon carbide epitaxial layer according to claim 1, wherein the epitaxial structure in the step (7) is a Junction Barrier Schottky, JBS, structure; a PIN structure; a Junction Field Effect Transistor, JFET, structure; a Metal Oxide Semiconductor Field Effect Transistor, MOSFET, structure; or a Static Induction Transistor, SIT, structure.

5. The method for reducing the influence of the basal plane dislocation on the silicon carbide epitaxial layer according to claim 1, wherein the doping type of the epitaxial layer is the same as the doping types of the highly doped buffer layer and the gradually changed buffer layer.

## Patentansprüche

1. Verfahren zum Züchten einer Siliziumkarbid-Epitaxieschicht, umfassend das Reduzieren der Ausdehnung einer Basisebenenversetzung auf einer Siliziumkarbid-Epitaxieschicht, umfassend die folgenden Schritte:
(1) Platzieren eines um 4 Grad oder 8 Grad in eine Richtung <11-20> abgelenkten Siliciumcarbidsubstrats auf einem Graphitsuszeptor in einer Reaktionskammer eines Siliciumcarbid-Epitaxiesystems;
(2) Ersetzen des Gases in der Reaktionskammer durch Argon, anschließendes Einbringen von Wasserstoff in die Reaktionskammer, allmähliches Erhöhen der Flussrate des Wasserstoffs auf 60 bis 120 l/min, Einstellen eines Drucks in der Reaktionskammer auf 80 bis 200 mbar, allmähliches Erhitzen der Reaktionskammer auf 1.550 bis 1.700 °C, wobei alle Parameter konstant gehalten werden, nachdem die Temperatur eine eingestellte Temperatur erreicht hat, und Durchführen einer In-situ-Wasserstoffätzbehandlung auf dem Siliciumcarbidsubstrat für 5 bis 15 Minuten;
(3) nach Abschluss der In-situ-Wasserstoffätzbehandlung Einführen einer Siliziumquelle und einer Kohlenstoffquelle in die Reaktionskammer, so dass das Flussratenverhältnis der Siliziumquelle zum Wasserstoff kleiner als 0,03% ist, und das Kohlenstoffquellen- zum Siliziumquellenverhältnis so gesteuert wird, dass es 0,85 ist, und Einführen einer Dotierungsquelle zum Züchten einer hochdotierte Pufferschicht mit einer Dicke von 0,5 bis 5 µm und einer Dotierungskonzentration von etwa 5E18 cm⁻³;
(4) Ausschalten der Silizium- und Kohlenstoffquelle, wobei die Silizium- und Kohlenstoffquelle eine Wachstumsquelle ist, und der Dotierungsquelle, Erhöhen der Wachstumstemperatur auf 1.700 bis 1.900 °C innerhalb von 10 Minuten in Form einer linearen Änderung, wodurch der Druck in der Reaktionskammer auf 500 bis 800 mbar erhöht wird, Reduzieren der Flussrate des Wasserstoffs auf 30 bis 60 l/min und Durchführen einer Hochtemperaturglühbehandlung an der hochdotierten Pufferschicht für 10 bis 60 min;
(5) Reduzieren der Wachstumstemperatur auf 1.550 bis 1.700 °C innerhalb von 10 min in Form einer linearen Änderung, Reduzieren des Drucks in der Reaktionskammer auf 80 bis 200 mbar und Erhöhen der Flussrate des Wasserstoffs auf 60 bis 120 l/min;
(6) Einführen der Siliziumquelle und der Kohlenstoffquelle in die Reaktionskammer, wobei die Strömungsraten der Siliziumquelle und der Kohlenstoffquelle die gleichen wie in Schritt (3) sind;
Einführen der Dotierungsquelle, deren anfängliche Flussrate dieselbe ist wie die in Schritt (3), und anschließendes allmähliches Reduzieren der Flussrate auf ein Fünftel, um eine allmählich veränderte Pufferschicht mit einer Dicke von 0,5 bis 2 heranzuzüchten und mit einer Dotierungskonzentration von etwa 1E18 cm⁻³, die allmählich von etwa 5E18 cm⁻³ verändert wurde;
(7) Ändern der Flussraten der Wachstumsquelle und der Dotierungsquelle, um Werte in einer allmählichen, linearen Form einzustellen, wobei alle Werte so eingestellt werden, dass sie eingestellte Werte sind, die durch das Heranzüchten einer Epitaxiestruktur und das Heranzüchten der Epitaxiestruktur erforderlich sind; und,
(8) nachdem das Wachstum der Epitaxiestruktur abgeschlossen ist, Abschalten der Wachstumsquelle und der Dotierungsquelle, Senken der Temperatur der Reaktionskammer auf Raumtemperatur in einer Wasserstoffatmosphäre, Abführen des Wasserstoff und Einführen von Argon, um das Gas in der Reaktionskammer zu ersetzen, Erhöhen des Drucks in der Reaktionskammer auf einen atmosphärischen Druck durch das Argon und Öffnen der Kammer zum Herausnehmen eines Wafers.

2. Verfahren zum Reduzieren des Einflusses der Basisebenenversetzung auf der Siliziumkarbid-Epitaxieschicht nach Anspruch 1, wobei die Dotierungsquelle eine Stickstoff-n-Typ-Dotierungsquelle oder eine Trimethylaluminium-p-Typ-Dotierungsquelle ist.

3. Verfahren zum Reduzieren des Einflusses der Basisebenenversetzung auf die Siliciumcarbid-Epitaxieschicht nach Anspruch 1, wobei die Siliciumquelle Silan, Dichlorwasserstoffsilicium, Trichlorsilan oder Tetrachlorhydrogensilicium ist und die Kohlenstoffquelle Methan, Ethylen, Acetylen oder Propan ist.

4. Verfahren zum Reduzieren des Einflusses der Basisebenenversetzung auf die Siliciumcarbid-Epitaxieschicht nach Anspruch 1, wobei die Epitaxiestruktur in Schritt (7) eine Junction Barrier Schottky(JBS)-Struktur;
eine PIN-Struktur;
eine Junction Field Effect Transistor(JFET)-Struktur;
eine Metalloxidhalbleiter-Feldeffekttransistor(MOSFET)-Struktur; oder
eine statische Induktionstransistor(SIT)-Struktur ist.

5. Verfahren zum Reduzieren des Einflusses der Basisebenenversetzung auf die Siliciumcarbid-Epitaxieschicht nach Anspruch 1, wobei der Dotierungstyp der Epitaxieschicht der gleiche ist wie die Dotierungstypen der hochdotierten Pufferschicht und der allmählich veränderten Pufferschicht.

## Revendications

1. Procédé destiné à la croissance d'une couche épitaxiale de carbure de silicium comprenant la réduction de l'extension d'une dislocation du plan de base sur une couche épitaxiale de carbure de silicium, comprenant les étapes suivantes :
(1) le placement d'un substrat de carbure de silicium dévié vers une direction <11-20> de 4 degrés ou de 8 degrés sur un suscepteur en graphite dans une chambre de réaction d'un système épitaxial de carbure de silicium ;
(2) le remplacement du gaz dans la chambre de réaction par de l'argon, puis l'introduction d'hydrogène dans la chambre de réaction, l'augmentation de manière progressive du débit d'hydrogène de 60 à 120 l/min, le réglage d'une pression dans la chambre de réaction de 80 à 200 mbar, le chauffage de manière progressive de la chambre de réaction de 1 550 à 1 700 °C, en maintenant tous les paramètres constants une fois que la température a atteint une température de consigne et la réalisation d'un traitement de gravure à l'hydrogène in situ sur le substrat de carbure de silicium pendant 5 à 15 min ;
(3) une fois le traitement de gravure à l'hydrogène in situ terminé, l'introduction d'une source de silicium et d'une source de carbone dans la chambre de réaction, de sorte que le rapport de débit de la source de silicium à l'hydrogène est inférieur à 0,03 % et le rapport de la source de carbone à la source de silicium est régulé pour être de 0,85 et l'introduction d'une source de dopage pour faire croître une couche tampon fortement dopée comportant une épaisseur de 0,5 à 5 µm et d'une concentration de dopage d'environ 5E18 cm⁻³ ;
(4) l'arrêt de la source de silicium et de carbone, la source de silicium et de carbone étant une source de croissance et la source de dopage, l'élévation de la température de croissance de 1 700 à 1 900 °C dans les 10 min d'une manière de modification linéaire, l'augmentation de la pression dans la chambre de réaction de 500 à 800 mbar, la réduction du débit d'hydrogène de 30 à 60 l/min et la réalisation d'un traitement de recuit à haute température sur la couche tampon fortement dopée pendant 10 à 60 min ;
(5) la réduction de la température de croissance de 1 550 à 1 700 °C dans les 10 min d'une manière de modification linéaire, la réduction de la pression dans la chambre de réaction de 80 à 200 mbar et l'augmentation du débit d'hydrogène de 60 à 120 l/min ;
(6) l'introduction de la source de silicium et de la source de carbone dans la chambre de réaction, les débits de la source de silicium et de la source de carbone étant les mêmes que ceux de l'étape (3) ;
l'introduction de la source de dopage dont le débit initial est le même que celui de l'étape (3), puis la réduction de manière progressive du débit à un cinquième pour faire croître une couche tampon modifiée de manière progressive comportant une épaisseur de 0,5 à 2 µm et une concentration de dopage d'environ 1E18 cm⁻³ modifiée de manière progressive à partir d'environ 5E18 cm⁻³ ;
(7) la modification les débits de la source de croissance et de la source de dopage pour définir des valeurs d'une manière graduelle et linéaire, toutes les valeurs étant définies pour être des valeurs définies requises par la croissance d'une structure épitaxiale et la croissance de la structure épitaxiale ; et
(8) une fois la croissance de la structure épitaxiale terminée, l'arrêt de la source de croissance et de la source de dopage, la réduction de la température de la chambre de réaction à la température ambiante dans une atmosphère d'hydrogène, puis l'évacuation de l'hydrogène, l'introduction de l'argon pour remplacer le gaz dans la chambre de réaction, l'augmentation de la pression dans la chambre de réaction à une pression atmosphérique par l'argon et l'ouverture de la chambre pour prélever une plaquette.

2. Procédé destiné à réduire l'influence de la dislocation du plan de base sur la couche épitaxiale de carbure de silicium selon la revendication 1, dans lequel la source de dopage est de l'azote en tant que source de dopage de type n ou du triméthylaluminium en tant que source de dopage de type p.

3. Procédé destiné à réduire l'influence de la dislocation du plan de base sur la couche épitaxiale de carbure de silicium selon la revendication 1, dans lequel la source de silicium est le silane, le dichlorure hydrogène silicium, le trichlorosilane ou le tétrachlorure hydrogène silicium et la source de carbone est le méthane, l'éthylène, l'acétylène ou le propane.

4. Procédé destiné à réduire l'influence de la dislocation du plan de base sur la couche épitaxiale de carbure de silicium selon la revendication 1, dans lequel la structure épitaxiale à l'étape (7) est une structure Schottky à barrière de jonction, JBS ;
une structure PIN ;
une structure de transistor à effet de champ à jonction, JFET ;
une structure de transistor à effet de champ à semiconducteur à oxyde métallique, MOSFET ; ou
une structure de transistor à induction statique, SIT.

5. Procédé destiné à réduire l'influence de la dislocation du plan de base sur la couche épitaxiale de carbure de silicium selon la revendication 1, dans lequel le type de dopage de la couche épitaxiale est le même que les types de dopage de la couche tampon fortement dopée et de la couche tampon modifiée de manière progressive.
